# EUROPEAN PATENT SPECIFICATION

(11) **EP 0 762 494 B1**
(45) Date of publication and mention of the grant of the patent: **24.07.2002**
(21) Application number: 95402057.4
(22) Date of filing: 12.09.1995
(51) Int. Cl.: H01L 23/051, H01L 25/07

(54) **Silicon semiconductor diode, its circuit module and structure with an insulation body and preparation method thereof**
Siliziumhalbleiterdiode, ihr Schaltungsmodul und Struktur mit einem isolierendem Körper und Herstellungsverfahren dafür
Diode semi-conductrice en silicium, son module de circuit et structure avec un corps isolant et procédé de préparation

(43) Date of publication of application: 12.03.1997
(73) Proprietor: Zowie Technology Corp., Hsin-Tien, Taipei (TW)
(72) Inventor: Tai, Chao-chih, Taipei Hsian (TW)
(74) Representative: Joly, Jean-Jacques

(56) References cited:
- DE-B- 1 276 210
- GB-A- 2 019 089
- US-A- 3 818 584

## Description

### Field of the Invention

The present invention relates to a structure of a silicon semiconductor diode chip and its insulation body and preparation method thereof, especially to a simplified structure of an assembly with a silicon semiconductor diode chip and its insulation body, and to a novel preparation method for silicon semiconductor diode. The structure and method of this invention are also suited for the preparation of other chip form bi-electrode electronic parts and circuit assemblies.

### Background of the Invention

The silicon semiconductor diode is a useful active component in the industry. Due to the large quantity and wide application of the silicon semiconductor diode, the industry keeps developing more effective and cost reduced approaches for the mass production of the silicon semiconductor diode.

A standard silicon semiconductor diode product comprises a silicon semiconductor diode chip, two metal leads and an insulation body. In the conventional approaches of the preparation of the silicon semiconductor diode, a diode chip is assembled with the metal leads first and then the assembly is encapsulated with the insulation body. In the conventional approaches the assembly of the insulation body with the diode chip-metal leads sub-assembly includes three categories of approaches, as follows.

### I) The insulation body is prepared separately.

In this category, the encapsulation insulation body part is not structurely assembled with the diode chip directly, but with the metal leads. Suited examples are : glass tube two-step seal packages, glass tube-double plug simultaneous seal packages and metal can packages.

### II) The insulation body material is cast in a mold to form the insulation body.

In this approach the diode chip-metal leads semi-assembly is inserted in a mold cavity. The insulation body is casted in the mold cavity and seals the sub-assembly. One of the commonly used materials for the cast insulation body is thermosetting plastic. Other materials which require treatment under higher temperature or higher pressure, such as ceramics or fiber glass reinforced resin etc are not suited to this approach, due to the limitation of the temperature cycling and the mechanical strength of the semi-assembly.

### III) The insulation body is coated on the soldered, or brazed, sub-assembly of the diode chip and the metal lead.

This approach includes : resin coated insulation body, glass beaded insulation body and conformal epoxy powder coated insulation body. Among them, the glass beaded insulation body has enhanced properties. One problem of this approach is that the insulation body needs to be applied to both sides of the diode chip and treated with hard brazing under high temperature. In this approach the electrodes are made from molybdenum or tungsten or alloys with heat expansion coefficients - close to that of silicon and glass passivation - and with high electric and heat conductivity. The limitation of materials means increased manufacture costs.

Among the aforementioned three categories, the glass beaded insulation body approach is the most effective. However, the manufacturing cost of this design is higher than that of the other approaches.

In the manufacturing process, a variety of molds and fixtures are needed and a high degree of automation is not possible. As a result, manufacturing costs remain high.

US-A-3 818 584 discloses a method for manufacturing a semiconductor apparatus, using a plurality of superposed prepreg layers perforated with through-holes. The prepreg layers are inserted between a pair of electrode plates. Semiconductor elements are arranged in the through-holes. Heat and pressure are applied to bond the electrode plates with the prepreg layers and to seal the semiconductor elements.

GB-A-2 019 089 discloses a semiconductor diode having a ring-like insulating glass member which is fused to the edge of the diode.

### Objects of the Invention

An object of the present invention is to provide a novel structure of diode chip-insulation body assembly of silicon semiconductor diode and its preparation method that enables materials not normally suited for processing on the diode sub-assembly to become applicable in the preparation of the insulation body.

Another object of the invention is to provide a novel structure for a diode chip-insulation body assembly of a silicon semiconductor diode and its preparation method suited for the mass production of diodes at higher production rates.

Another object of this invention is to provide a novel structure for a diode chip and insulation body of a silicon semiconductor diode and its preparation method enabling the coating of the open junction of the diode chip to be conducted simultaneously along with the assembly of the diode chip and the insulation main body.

Another object of this invention is to provide a structure for the diode chip and insulation body assembly of silicon semiconductor diode and its method of preparation whereby the open P-N junction of the diode chip may be well protected during the manufacturing process.

### Summary of the Invention

According to the present invention, an insulation body structure is formed within a captive multi-unit configuration on which multiple mounting sites for diode chips are prepared. Each diode chip is located at one of the mounting sites and is coated and bonded to the surface of the mounting site with bonding material. A plurality of diode chips may be assembled in the insulation body structure in one single step. The specifics of the invention are recited in claim 1.

The following processes may take place on the connected insulation body structure. Units of single or plural diodes are separated after the preparation process is completed.

The structure of the diode chip-insulation body assembly of this invention is a direct construction of the diode chip. The insulation body of this invention is totally different from that of the conventional art.

### Brief Description of the Drawings

The above and other objects and advantages of this invention may be more clearly understood from the following description by referring to the following drawings, in which :
Figure 1 illustrates the structure of a diode chip-insulation body assembly of the silicon semiconductor diode chip of the invention;
Figure 2 illustrates its sectional view along the line A-A of figure 1;
Figure 3 illustrates the flowchart of one embodiment of the preparation method for the manufacture of a silicon semiconductor diode chip according to the invention;
Figure 4 illustrates a front view of an insertion pin type rectifier according to an embodiment of this invention;
Figure 5 illustrates its sectional view along the line B-B of figure 4;
Figure 6 illustrates a sectional view of an insertion pin type rectifier assembly prepared by the method of the invention;
Fig 7 illustrates a front view of an SMD (surface-mounted device) type silicon rectifier according to an embodiment of the invention;
Figure 8 illustrates its sectional view along the line C-C of figure 7;
Figure 9 illustrates the structure of an SMD type silicon rectifier assembly prepared by the method of the invention;
Figure 10 illustrates the structure of a ceramic plate semiconductor diode assembly according to an embodiment of the invention;
Figure 11 shows the sectional view of a ceramic plate semiconductor diode prepared according to the method of the invention; and
Figure 12 shows the structure of a bridge rectifier prepared according to the method of the invention.

### Detailed Description of the Invention

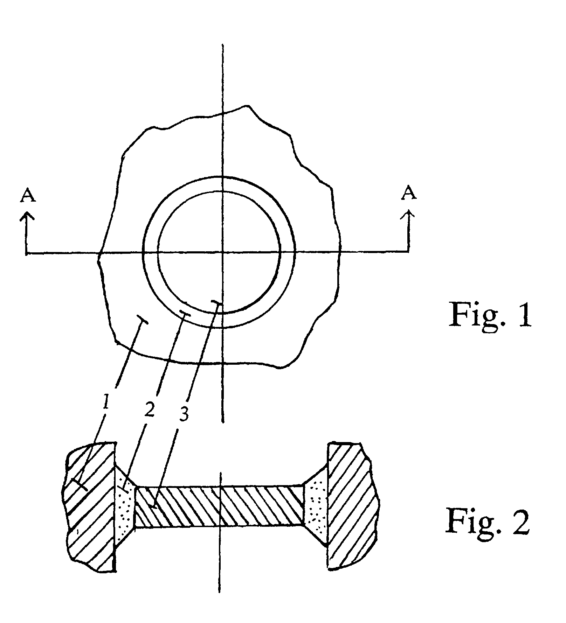

Figure 1 illustrates an example of the structure of a diode chip-insulation body assembly of the silicon semiconductor diode chip according to the invention. Figure 2 is a sectional view of that diode chip along the line A-A of figure 1.

As shown in the figures, the structure of the silicon semiconductor diode chip-insulation body assembly includes an insulation body main structure 1, a silicon semiconductor diode chip 2 and a bonding material 3.

Semiconductor diode chips as applicable in this invention include inter alia:
1. diode chips treated with chip separation cut and chemical polish and oxidation with open P-N junction, and
2. P-N junction coated diode chips.

The insulation body applicable to the invention may be a connected, insulation body structure made from any suitable material. On the insulation body structure, a plurality of chip mounting sites are prepared. In practice, the chip mounting sites include through-holes in the insulation body structure. The bonding surface may be the wall of the through holes. Each mounting site has a bonding surface. Sealing material is applied between the open junction surface of the diode chip and the bonding surface (wall) of the mounting site. In the preparation process, the positive and negative electrode surfaces of the diode chip are not coated with the bonding material. An open space is preserved over the surface of both sides (the electrodes) of the chip so that conducting parts may be mounted thereon.

In general, a ceramic plate is a good example of applicable material for the insulation body structure.

In the invention, the insulation body structure is connected so that plural units of diode chips or diode assemblies may be prepared simultaneously in one multi-unit insulation body structure during the preparation process.

The bonding material is applied between the open junction of the diode chip and the chip mounting site to bond the chip firmly at the mounting site.

In the new structure disclosed in the invention, the bonding material acts as the P-N junction coating material, if applied to a diode chip where the P-N junction is not pre-coated.

Bonding materials suited in this invention may be any applicable material. Passivation glass is one good example of the bonding material.

The following is a description of the preparation process of this invention.

First, at 101, a multi-unit type of insulation body board 1 is prepared. In general, a ceramic plate is a suitable example. At 102, a plurality of chip mounting sites la are prepared on the insulation body board 1. In the application, the mounting sites la are round, oval conoidal, or rectangular through-holes prepared in the board 1. Diode chips 3 are prepared as in the conventional art. In general, the chips 3 are sand blasted round mesa shaped dice or rectangular mesa shaped dice sawed by a dicing saw. The chips 3 are pre-treated with chemical polish and oxidation.

At 103, the bonding material 2 is applied to the mounting sites la with a positioning fixture and at 104 the bonding material is applied on the wall of the mounting site. The bonding material 2 may be passivation glass or sinterred glass (when a ceramic board is applied).

At 105, the diode chips 3 are mounted into the mounting sites la by applicable means, such as vacuum needles.

In one embodiment of the present invention, the diode chips 3 are soft-soldered with conducting parts at 103 and are mounted into the mounting sites la at 104 and the bonding material 2 is applied at 105.

In one embodiment of the invention, the mounting sites are conoidal holes wherein the dimension of the openings on one side of the board is larger that that on the other side. In this embodiment the location of the diode chips 3 in the mounting sites can be more accurate.

At 106, the assembly as prepared from 105, is treated. If the bonding material is passivation glass, the glass is vitrified in a furnace. In this step, the passivation coating of the P-N junction and the bonding of the diode chip 3 are completed in one single step simultaneously. At 107, metal leads are mounted with both sides of the diode chip. Packaging and overmolding are completed at 108, if necessary.

Because the diode chip 3 in the present invention is first assembled with the connected insulation body structure the following process may be conducted on the solid insulation body structure. As a result, the diode chips of high quality may be prepared in a large quantities and under lower manufacturing requirements or conditions.

Several embodiments of the present invention shall now be described.

### Embodiment 1

The example is based on the preparation of the insertion pin type silicon-rectifiers.

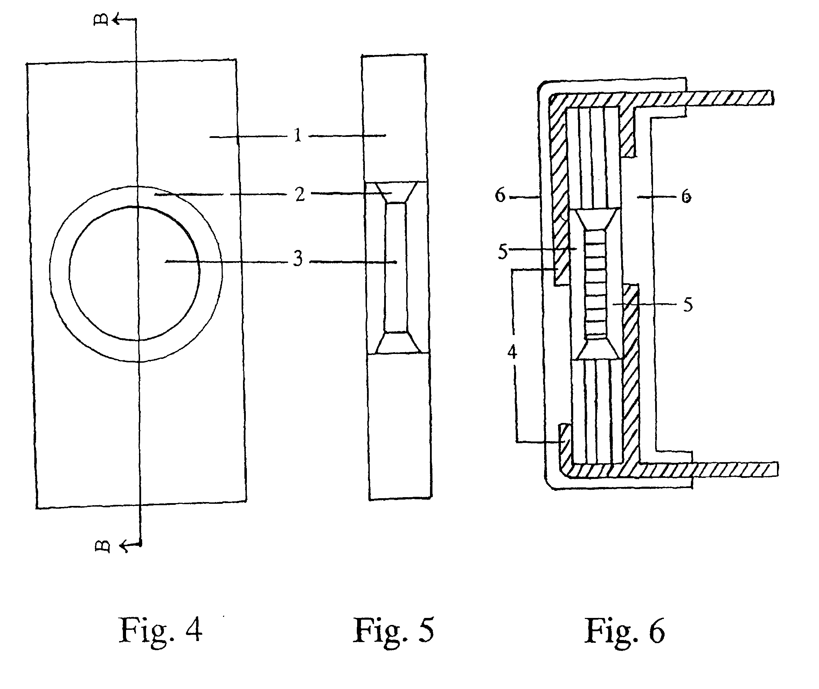

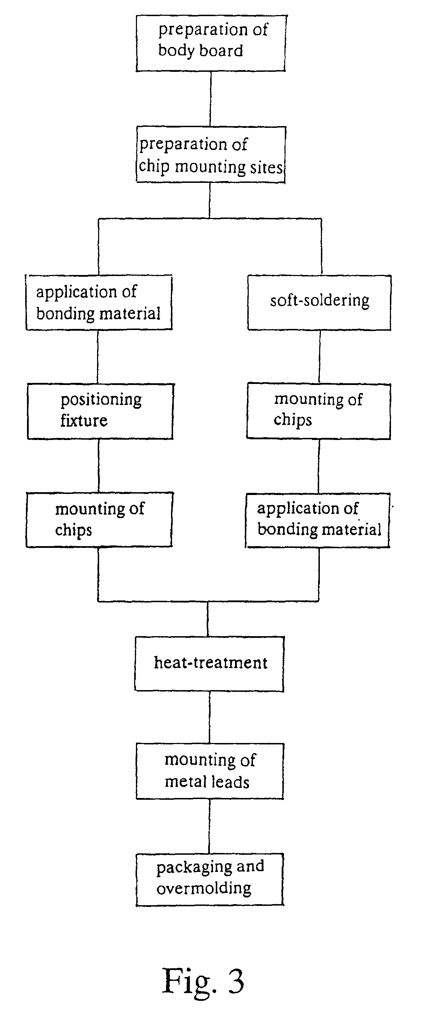

Figure 4 illustrates a front view of an insertion pin type silicon-rectifier prepared according to the method of the present invention. Figure 5 is a sectional view of the silicon-rectifier of Figure 4 along line A-A of figure 3.

The preparation of the rectifier of this embodiment includes the following steps :
1) Diode chips 3 are sand blasted into round mesa shape and treated with chemical polish and oxidation.
2) The insulation main body structure 1 is prepared as a high alumina ceramic plate, pre-scored to form connected parts containing a plurality of units. Figure 4 shows the front view of one unit of the connected parts. Figure 5 is its sectional view. One through-hole is prepared in each unit, as shown in Figs. 4 and 5. The through-holes function as mounting sites for the diode chips.
3) Passivation glass powder is added with water and blended into a slurry to be used as the bonding material 2.
4) A certain quantity of slurry glass is applied onto the wall of each through-hole with a multi-application tip fixture. One diode chip 3 is mounted in each through-hole (mounting site) 1a to let the open junction of the diode chip 3 contact with the bonding glass.
5) The ceramic plate 1 is heated in an electric furnace where the glass 2 is melted and the P-N junction of the diode chip is passivated and coated, and bonded onto the ceramic plate 1.
6) Metal leads are soldered to both sides of the diode chip. Surface insulation finish is applied. The ceramic plate is then separated into chips. Packaging is completed.

Figure 6 show a sectional view of a finished insertion pin type rectifier prepared according to the method of the present invention. The diode chip-insulation material assembly as prepared through steps 1 to 5 is connected with metal leads and insertion pins 4 with solder 5 at both open sides of the diode chip 3. The assembly is then packaged with insulation resin 6 and a diode assembly suited for insertion process is prepared.

### Embodiment 2 (this embodiment is not within the scope of claims 1 and 6, but is useful for the understanding of the invention)

The following example is applied to an SMD type silicon-rectifier.

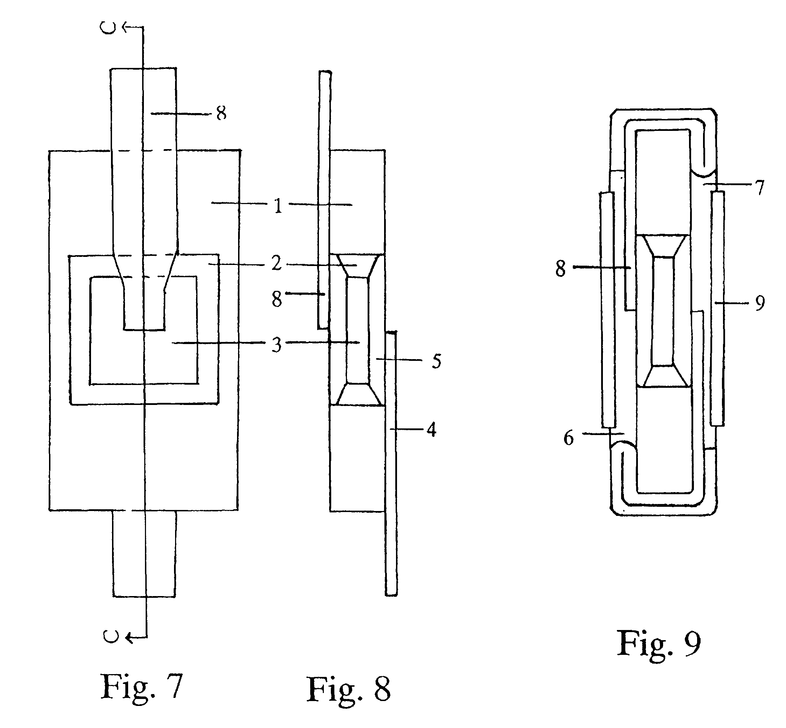

Figure 7 shows a front view of a SMD type rectifier, as prepared according to the method of this invention. Figure 8 is a sectional view of the rectifier of Figure 7 at line B-B of figure 6.

The preparation of the SMD type rectifier includes the following steps
1) Diode chips 3 are prepared as rectangular dices sawed by a dicing saw. Soft soldering is applied to mount a die onto a lead 8. The die is then treated with chemical polish and oxidation.
2) An insulation main body board is prepared. In this embodiment, the insulation body board is a fiber glass reinforced plastic plate. The insulation body board is a strip or a plate of connected parts or units. Each unit has at least one through-hole to function as a chip mounting site, as shown in Figs. 7 and 8.
3) P-N junction coating resin such as siloxane is prepared as bonding material 2.
4) The lead 8, soldered with a diode chip 3, is inserted into a mounting site la in the insulation body board 1 and the diode chip 3 is located in the middle of the mounting site 1a.
5) The coating material 2 is applied to the P-N junction area, between the diode chip 3 and the wall of the mounting hole la and is then cured
6) Cover plates 9 are mounted on both sides of the diode chip 3 and sealed with adhesives. The SMD type rectifier is prepared.

Figure 9 shows the SMD type rectifier as prepared in this embodiment. In the process, cover plates 9 made from fiber glass resin are mounted on both sides of the diode chip of the assembly prepared through steps 1 to 5. The cover plates are sealed with adhesive 6, and the adhesive 6 is then cured. The lead 8 is then folded to form outside terminals and a rectifier assembly suited for surface mounting process is prepared.

The diode so prepared may be tested, separated and packaged according to the industrial specifications.

### Embodiment 3

The application of the present invention is in this case applied to a ceramic plate type semiconductor diode.

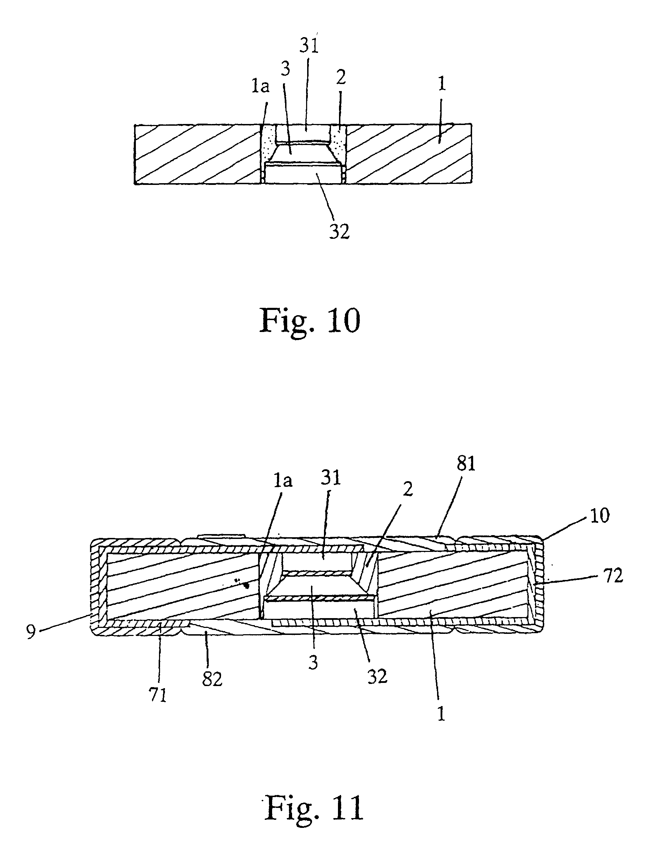

Figure 10 shows the structure of a ceramic plate type semiconductor diode assembly prepared according to an embodiment of the invention.

The preparation of the ceramic plate type semiconductor diode includes the following steps :
1) Diffusion of the open junction of the diode chip. Both sides of a diode wafer 3 are evaporated with aluminum film. The wafer 3 is then sand blasted and separated into round mesa shaped dice. The dice are collected, cleaned with solvents and polished with acids.
2) Brazing of molybdenum electrodes. A molybdenum negative electrode 31 is mounted to the upper surface of the diode dice 3 and a molybdenum positive electrode 32 is mounted to the bottom surface of the dice 3. Aluminum brazing joints are formed between the molybdenum electrodes and the diode chip by heating in an electric furnace to melt the aluminum film.
3) Polish and oxidation of the open junction of the semi-assembled diode dice. The open junction of the diode chip is chemically polished and oxidized.
4) Mounting of the brazed sub-assembly. The high alumina ceramic plate 1 is pre-scored to make an insulation body board containing plural units 1b. One mounting site 1a is prepared in each unit. One brazed sub-assembly is positioned into the mounting site 1a of the insulation unit 1b.
5) Bonding of the brazed sub-assembly. Glass powder is blended with pure water into a slurry and is applied between the brazed sub-assembly and the mounting site 1a. The assembly is then heated in an electric oven to vitrify the glass 2. The diode chip 3 is coated and is bonded firmly to the mounting site 1a simultaneously.
6) Assembling the electrodes, overmolding and curing. Thick film silver paste is printed on both sides of the insulation body-diode chip assembly with a screen printer to form electrodes 71 and 72. Thick film glass slurry is also printed with a screen printer and heated to form a glass cover layer on each side of the assembly.
7) Printing the terminals. Terminals 9 and 10 arc printed with thick film silver slurry and are sinterred. The bare area of the terminals 9 and 10 and electrodes 71 and 72 is treated with hot solder dip. The insulation body board assembled with diode chips is then bent at the pre-scored groove and separated. A ceramic plate type semiconductor diode assembly is then obtained.
8) The diode assembly so prepared may be tested, classified and packaged automatically.

Figure 11 shows the sectional view of a ceramic plate type semiconductor diode prepared according to the method of this invention.

### Embodiments 4 to 6

The above preparation method may be applied to the preparation of the following types of diode, with minor changes.
1) Axial lead diodes,
2) Multi-chip high voltage diodes, and
3) Diode circuitry modules,

Of course, other bi-electrode electronic parts may be prepared according to similar arts of this invention.

### Embodiment 7

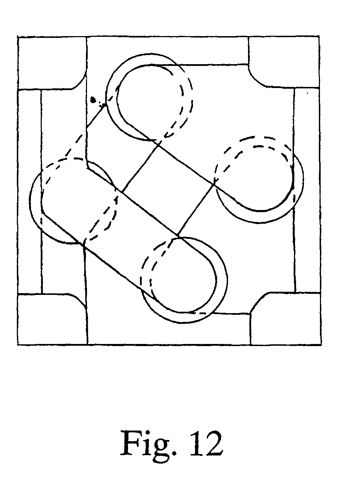

The example is applied to a bridge rectifier;
the invention is indeed amenable to some complicated circuits such as bridge rectifiers. The preparation of bridge rectifier, adopting the method of this invention, includes the following steps :
1) Insulation of the main body part where one unit contains 4 mounting sites is prepared.
2) Mounting the diode chips onto the mounting sites of the insulation body according to Steps 2 to 7 of embodiment 4.
3) Mounting conducting parts on the diode chip assembly so that the diodes form a electric circuit as a bridge rectifier. Four terminals with + and - inputs and + and - outputs are formed. The bridge rectifier so prepared is shown in Figure 12.
4) The bridge rectifier is then coated or covered with cover plate, if necessary.

In this embodiment, the insulation body, the conducting part and the cover plate may be prepared as a large plate with connected parts. All the preparation process, including the mounting of the diode chips and the cover plate and the soldering of the conducting parts, may be conducted in batches. The outer terminal of the conducting parts may be processed with preserved terminal holes.

### Effects of the Invention

According to the invention, the fundamental structure of silicon semiconductor diode assembly comprises an insulation body, a diode chip and the bonding material. The insulation body functions as a fixture and an insulation body. The bonding material functions as the coating material of the open P-N junction of the diode chip. The manufacturing costs may thus be reduced.

In the preparation method of this invention, a connected part of insulation body board is adopted. A large number of diodes may be prepared simultaneously. The preparation process is simplified and the cost is reduced.

The method of the invention is applicable to P-N junction coated or non coated diode chips and to diode chip stacks. The mounting sites may be mounted on one single diode dice or plural diode dices. Conducting leads or circuitry may be pre-printed on the insulation body structure to prepare specially designed circuits.

In practice, the diode assembly so prepared may be soldered with conducting parts, or open spaces may be reserved for the connection of electrodes or conducting parts. The conducting parts may be mounted before or after the diode chip is mounted. If the conducting parts are mounted after the diode chip is mounted, they may be mounted on the insulation body or with the diode chip.

As described above, the silicon semiconductor diode assembly of this invention has a new structure which is totally different from the prior art. The structure and method of this invention simplify the preparation of silicon semiconductor diode with dramatic effectiveness.

As the invention has been shown and described with reference to preferred embodiments thereof, those skilled in the art will recognize that the above and other changes may be made therein without departing from the scope of the claims.

## Claims

1. Structure of at least one diode chip and an insulation board (1) comprising :
an insulation board (1) containing a plurality of insulation units wherein each insulation unit comprises at least one mounting site (1a) in the form of a through-hole for at least one diode chip (3);
at least one diode chip, mounted in one of said at least one mounting sites of said insulation board; and
a bonding material (2) to bond said at least one diode chip in its corresponding mounting site; wherein said bonding material (2) is not coated on the surfaces of said at least one diode chip that do not face its corresponding mounting site (1a),
**characterized in that** said insulation board (1) is a ceramic plate and said bonding material (2) is glass.

2. Structure according to claim 1, **characterized in that** said bonding material (2) functions as the coating material of an open junction of said at least one diode chip (3).

3. Structure according to claim 2, **characterized in that** said junction consists of a P-N junction.

4. Structure according to any one of claims 1 to 3, **characterized in that** said bonding material (2) is sintered glass.

5. Structure according to any one of claims 1 to 4, **characterized in that** each insulation unit comprises a plurality of mounting sites.

6. Method for the preparation of diode part assemblies comprising:
preparation of at least one chip forming a diode (3) :
preparation of an insulation board (1) with a plurality of insulation units (step 101);
preparation of at least one mounting site (1a) in the form of a through hole for at least one said chip (3) in each of said insulation units (step 102); and
bonding said at least one said chip (3) in said at least one mounting site (1a) using a bonding material (2) (step 103);
**characterized in that** said insulation board (1) is a ceramic plate and said bonding material (2) is glass, and **in that** said bonding material (2) is not coated on the surfaces of said at least one said chip that do not face its corresponding mounting site.

7. Method according to claim 6, **characterized in that** said bonding material (2) is sintered glass.

8. Method according to claim 6 or 7, **characterized in that** each insulation unit comprises a plurality of mounting sites.

9. Method according to any one of claims 6 to 8, **characterized in that** said bonding step comprises the following steps:
applying said bonding material (2) on the surface of said at least one mounting site (1a); and then
mounting said at least one said chip (3) in said at least one mounting site.

10. Method according to any one of claims 6 to 8, **characterized in that** said bonding step comprises the following steps:
mounting said at least one said diode chip (3) in said at least one mounting site (1a); and then
applying said bonding material (2) between said at least one said chip and the surface of said at least one mounting site.

## Patentansprüche

1. Struktur zumindest eines Diodenchips und eines Isolierträgers (1), umfassend:
einen Isolierträger (1), der eine Mehrzahl von Isoliereinheiten enthält, von denen jede Isoliereinheit mindestens eine Lagerstelle (1a) in Form eines Durchgangslochs für mindestens ein Diodenchip (3) enthält;
mindestens ein Diodenchip, gehaltert an einer der mindestens einen Lagerstelle des Isolierkörpers; und
ein Bondmaterial (2) zum Bonden des mindestens einen Diodenchips an der ihm zugehörigen Lagerstelle, wobei das Bondmaterial (2) nicht auf die Oberflächen des mindestens einen Diodenchips aufgebraucht ist, welche nicht seiner zugehörigen Lagerstelle (1a) zugewandt sind,
**dadurch gekennzeichnet, dass** der Isolierkörper (1) ein Keramikplättchen und das Bondmaterial Glas ist.

2. Struktur nach Anspruch 1, **dadurch gekennzeichnet, dass** das Bondmaterial (2) als das Überzugmaterial eines offenen Übergangs des mindestens einen Diodenchips (3) fungiert.

3. Struktur nach Anspruch 2, **dadurch gekennzeichnet, dass** der Übergang ein P-N-Übergang ist.

4. Struktur nach einem der Ansprüche 1 bis 3, **dadurch gekennzeichnet, dass** das Bondmaterial (2) gesintertes Glas ist.

5. Struktur nach einem der Ansprüche 1 bis 4, **dadurch gekennzeichnet, dass** jede Isoliereinheit eine Mehrzahl von Lagerstellen aufweist.

6. Verfahren zum Herstellen von Diodenteil-Anordnungen, umfassend:
Herstellen mindestens eines eine Diode (3) bildenden Chips;
Herstellen eines Isolierkörpers (1) mit einer Mehrzahl von Isoliereinheiten (Schritte 101);
Herstellen mindestens einer Lagerstelle (1a) in Form eines Durchgangslochs für mindestens ein Chip (3) in jeder der Isoliereinheiten (Schritt 102); und
Bonden des mindestens einen Chips (3) an der mindestens einen Lagerstelle (1a) unter Verwendung eines Bondmaterials (2) (Schritt 103),
**dadurch gekennzeichnet, dass** der Isolierkörper (1) ein Keramikplättchen ist und das Bondmaterial (2) Glas ist und dass das Bondmaterial (2) nicht auf diejenigen Oberflächen des mindestens einen Chips aufgebracht ist, die nicht dessen Lagerstelle zugewandt sind.

7. Verfahren nach Anspruch 6, **dadurch gekennzeichnet, dass** das Bondmaterial (2) gesintertes Glas ist.

8. Verfahren nach Anspruch 6 oder 7, **dadurch gekennzeichnet, dass** jede Isoliereinheit mehrere Lagerstellen aufweist.

9. Verfahren nach einem der Ansprüche 6 bis 8, **dadurch gekennzeichnet, dass** der Bond-Schritt folgende Schritte beinhaltet:
Aufbringen des Bondmaterials (2) auf die Oberfläche der mindestens einen Lagerstelle (1a); und anschließendes
Anbringen des mindestens einen Chips (3) an der mindestens einen Lagerstelle.

10. Verfahren nach einem der Ansprüche 6 bis 8, **dadurch gekennzeichnet, dass** der Bond-Schritt folgende Schritte beinhaltet:
Anbringen des mindestens einen Diodenchips (3) an der mindestens einen Lagerstelle (1a); und anschließendes
Anbringen des Bondmaterials (2) zwischen dem mindestens einen Chip und der Oberfläche der mindestens einen Lagerstelle.

## Revendications

1. Structure d'au moins une puce de diode et d'une carte d'isolation (1) comprenant :
une carte d'isolation (1) contenant une pluralité d'unités d'isolation, où chaque unité d'isolation comprend au moins un site de montage (1a) se présentant sous la forme d'un trou passant destiné à au moins une puce de diode (3) ;
au moins une puce de diode, montée dans l'un dudit au moins un site de montage de ladite carte d'isolation ; et
un matériau de liaison (2) servant à lier ladite au moins une puce de diode dans son site de montage correspondant ;
où ledit matériau de liaison (2) n'est pas déposé sur les surfaces de ladite au moins une puce de diode qui ne font pas face à son site de montage (1a) correspondant,
**caractérisée en ce que** ladite carte d'isolation (1) est une plaque de céramique et ledit matériau de liaison (2) est du verre.

2. Structure selon la revendication 1, **caractérisée en ce que** ledit matériau de liaison (2) fait fonction du matériau de revêtement d'une jonction ouverte de ladite au moins une puce de diode (3).

3. Structure selon la revendication 2, **caractérisée en ce que** ladite jonction consiste en une jonction P-N.

4. Structure selon l'une quelconque des revendications 1 à 3, **caractérisée en ce que** ledit matériau de liaison (2) est du verre fritté.

5. Structure selon l'une quelconque des revendications 1 à 4, **caractérisée en ce que** chaque unité d'isolation comprend une pluralité de sites de montage.

6. Procédé de préparation d'ensembles de parties de diode, comprenant :
la préparation d'au moins une puce formant une diode (3) ;
la préparation d'une carte d'isolation (1) ayant une pluralité d'unités d'isolation (étape 101) ;
la préparation d'au moins un site de montage (1a) se présentant sous la forme d'un trou passant destiné à au moins une dite puce (3) dans chacune desdites unités d'isolation (étape 102) ; et
la liaison de ladite au moins une dite puce (3) dans ledit au moins un site de montage (1a) au moyen d'un matériau de liaison (2) (étape 103) ;
**caractérisé en ce que** ladite carte d'isolation (1) est une carte de céramique et ledit matériau de liaison (2) est du verre, et **en ce que** ledit matériau de liaison (2) n'est pas déposé sur les surfaces de ladite au moins une dite puce qui ne font pas face à son site de montage correspondant.

7. Procédé selon la revendication 6, **caractérisé en ce que** ledit matériau de liaison (2) est du verre fritté.

8. Procédé selon la revendication 6 ou 7, **caractérisé en ce que** chaque unité d'isolation comprend une pluralité de sites de montage.

9. Procédé selon l'une quelconque des revendications 6 à 8, **caractérisé en ce que** ladite opération de liaison comprend les opérations suivantes :
appliquer ledit matériau de liaison (2) à la surface dudit au moins un site de montage (1a) ; puis
monter ladite au moins une dite puce (3) dans ledit au moins un site de montage.

10. Procédé selon l'une quelconque des revendications 6 à 8, **caractérisé en ce que** ladite opération de liaison comprend les opérations suivantes :
monter ladite au moins une dite puce de diode (3) dans ledit au moins un site de montage (1a) ; puis
appliquer ledit matériau de liaison (2) entre ladite au moins une dite puce et la surface dudit au moins un site de montage.
